# EUROPEAN PATENT SPECIFICATION

(11) **EP 4 020 543 B1**
(45) Date of publication and mention of the grant of the patent: **30.08.2023**
(21) Application number: 20869225.1
(22) Date of filing: 24.09.2020
(51) Int. Cl.: H01L 23/36, H05K 7/20, H01L 23/373

(54) **HEAT DISSIPATION SHEET, HEAT DISSIPATION SHEET LAYERED BODY, STRUCTURE, AND METHOD FOR DISSIPATING HEAT FROM HEAT-GENERATING ELEMENT**
WÄRMEABLEITSCHICHT, WÄRMEABLEITSCHICHTKÖRPER, STRUKTUR UND VERFAHREN ZUR WÄRMEABLEITUNG AUS EINEM WÄRMEERZEUGENDEN ELEMENT
FEUILLE DE DISSIPATION DE CHALEUR, STRATIFIÉ DE FEUILLE DE DISSIPATION DE CHALEUR, STRUCTURE, ET PROCÉDÉ DE TRAITEMENT DE DISSIPATION DE CHALEUR POUR ÉLÉMENT CHAUFFANT

(30) Priority: 25.09.2019 JP 2019173941
(43) Date of publication of application: 29.06.2022
(73) Proprietor: Denka Company Limited, Tokyo 103-8338 (JP)
(72) Inventor: WADA, Kosuke, Tokyo 103-8338 (JP); KANEKO, Masahide, Tokyo 103-8338 (JP); NONOGAKI, Ryozo, Tokyo 103-8338 (JP)
(74) Representative: Gulde & Partner
(86) International application number: PCT/JP2020/035909
(87) International publication number: WO 2021/060319

(56) References cited:
- JP-A- 2005 005 671
- JP-A- 2005 251 921
- JP-A- 2012 004 468
- JP-A- 2019 067 801

## Description

### Technical Field

The present invention relates to a heat-radiating sheet, a heat-radiating sheet laminate including the heat-radiating sheet, a structure including the heat-radiating sheet, and a heat-radiating treatment method of a heat-generating element using the heat-radiating sheet.

### Background Art

In heat-generating elements, such as power devices, transistors, thyristors, and CPUs, how to efficiently radiate heat generated at the time of use is an important issue. As a countermeasure against such heat radiation, in general, the heat radiation has hitherto been performed by conducting the heat generated from the heat-generating element into a heat-radiating component, such as a heat sink. In order to thermally conduct the heat generated from the heat-generating element with efficiency into the heat-radiating component, it is desired to fill an air gap with a heat-radiating material at a contact interface between the heat-generating element and the heat-radiating component. Heat-radiating sheets have hitherto been used as such a heat-radiating material because of easy handling (see, for example, PTL 1).

### Citation List

### Patent Literature

PTL: JP 2012-39060 A

### Summary of Invention

### Technical Problem

However, since the heat-radiating sheet cannot follow micro unevennesses on the mounting surface of the heat-generating element, there is a case where adhesion of the heat-radiating sheet to the heat-generating element is insufficient. Accordingly, there was a case where contact thermal resistance between the heat-generating element and the heat-generating sheet becomes large.

As a result of extensive and intensive investigations made by the present inventors, it has been found that by allowing a heat-radiating grease to intervene between the heat-generating element and the heat-radiating sheet, the contact thermal resistance between the heat-generating element and the heat-radiating sheet can be reduced. But, the present inventors have also found that when the heat-radiating grease is allowed to intervene between the heat-generating element and the heat-radiating sheet, a remarkable pump-out phenomenon (phenomenon in which the heat-radiating grease flows out from a mounting section) occurs in the heat-radiating grease due to thermal expansion and thermal contraction of the heat-radiating sheet.

Then, an object of the present invention is to provide a heat-radiating sheet which when allowing a heat-radiating grease to intervene between a heat-generating element and a heat-radiating sheet, is able to suppress a pump-out phenomenon of the heat-radiating grease, a heat-radiating sheet laminate including the heat-radiating sheet, a structure including the heat-radiating sheet, and a heat-radiating treatment method of a heat-generating element using the heat-radiating sheet.

### Technical Problem

In order to achieve the aforementioned object, the present inventors made extensive and intensive investigations. As a result, it has been found that in the case of performing a predetermined heat cycle test by sandwiching a heat-radiating grease by a heat-radiating sheet placed on an aluminum plate and a glass plate, the aforementioned object can be achieved by using a heat-radiating sheet in which an area ratio of an area of the heat-radiating grease after the heat cycle test to an area of the heat-radiating grease before the heat cycle test falls within a predetermined range.

The present invention is based on the aforementioned findings, and a gist thereof is as follows.
[1] Aheat-radiating sheet, wherein when a heat cycle test of one cycle in which 3.2 mL of a heat-radiating grease having a viscosity at 25°C at a shear velocity of 10 s⁻¹ of 22 Pa s and a bond line thickness (BLT) of 52 pm is sandwiched between a heat-radiating sheet of 180 mm × 100 mm arranged on an aluminum plate and a glass plate by a clamping force of 0.2 MPa per unit area, and after expanding the heat-radiating grease, the heat-radiating sheet is held at a temperature of -40°C for 30 minutes and then held at a temperature of 125°C for 30 minutes, is performed 100 cycles, an area ratio (S2/S1) of an area (S2) of the heat-radiating grease after performing the heat cycle test of 100 cycles to an area (S1) of the heat-radiating grease expanded before performing the heat cycle test is 1.0 to 2.0.
[2] The heat-radiating sheet as set forth above in [1], wherein the area ratio (S2/S1) is 1.0 to 1.7.
[3] A heat-radiating sheet laminate including the heat-radiating sheet as set forth above in [1] or [2], which has a first surface and a second surface on the opposite side to the first surface; and a heat-radiating grease layer formed on at least one surface of the first surface and the second surface of the heat-radiating sheet.
[4] A structure including the heat-radiating sheet as set forth above in [1] or [2], a heat-generating element placed on the heat-radiating sheet, and a heat-radiating grease intervening between the heat-radiating sheet and the heat-generating element.
[5] A heat-radiating treatment method including a step of applying the heat-radiating sheet according to claim 1 or 2, which has a first surface and a second surface on the opposite side to the first surface, with a heat-radiating grease on at least one surface of the first surface and the second surface; and a step of arranging a heat-generating element on the surface of the heat-radiating sheet, on which the heat-radiating grease has been applied.

### Advantageous Effects of Invention

In accordance with the present invention, it is possible to provide a heat-radiating sheet which when allowing a heat-radiating grease to intervene between a heat-generating element and a heat-radiating sheet, is able to suppress a pump-out phenomenon of the heat-radiating grease, a heat-radiating sheet laminate including the heat-radiating sheet, a structure including the heat-radiating sheet, and a heat-radiating treatment method of a heat-generating element using the heat-radiating sheet.

### Brief Description of Drawings

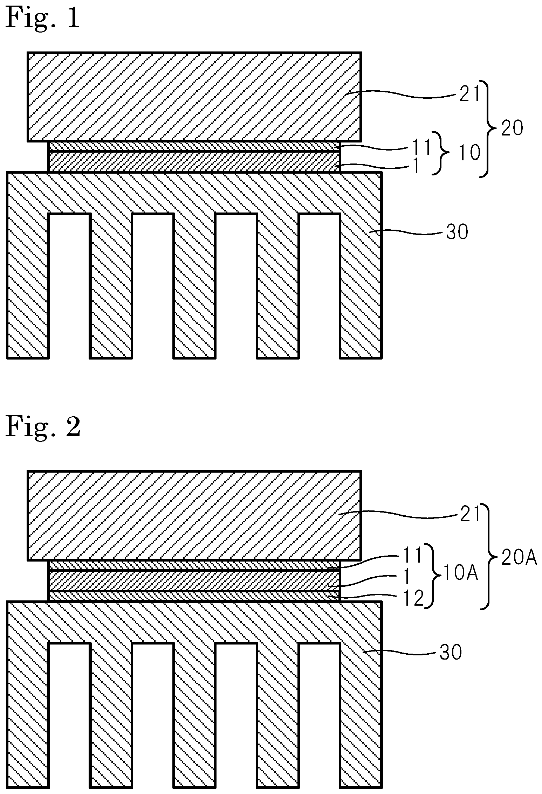

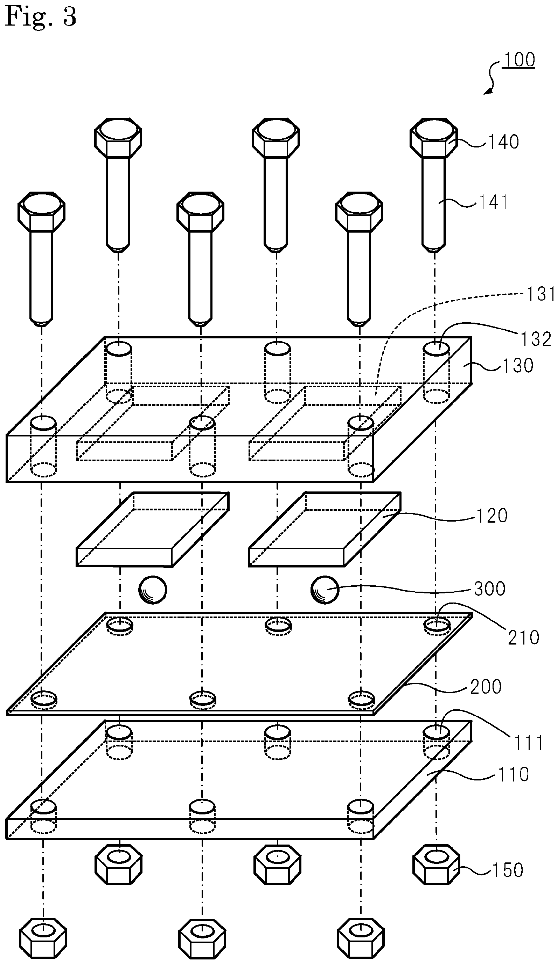

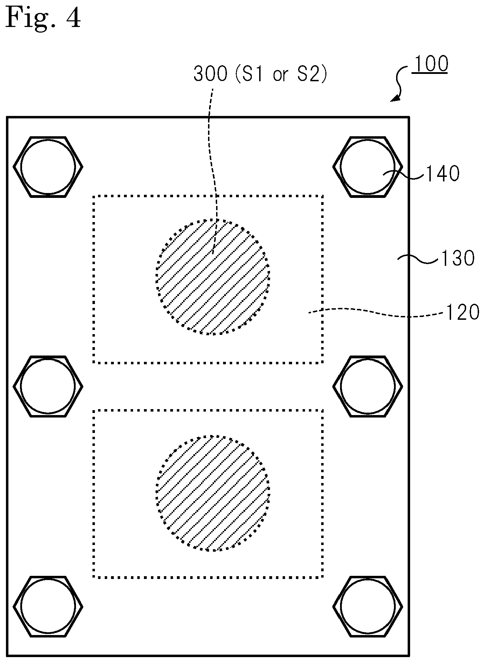

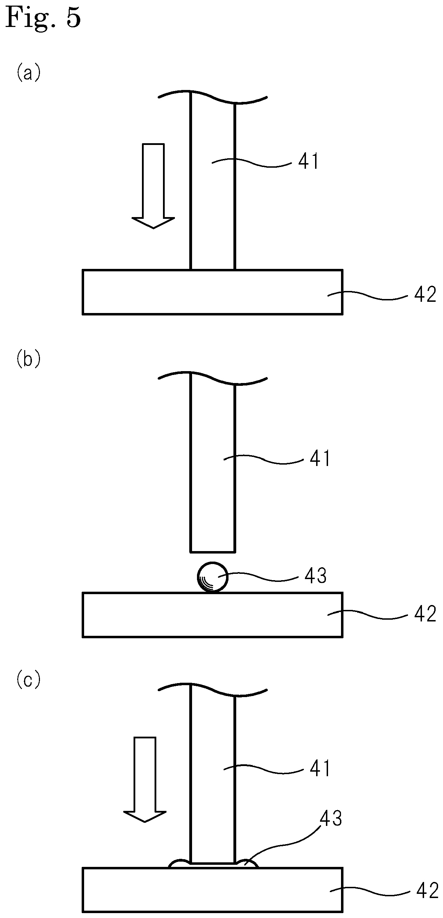

"Fig. 1" is a view for explaining heat-radiating sheet laminate and structure of an embodiment of the present invention.
"Fig. 2" is a view for explaining a modification example of heat-radiating sheet laminate and structure of an embodiment of the present invention.
"Fig. 3" is an exploded view of an area ratio evaluating tool used for the heat cycle test in the Examples.
"Fig. 4" is a view for explaining an expanse of a heat-radiating grease in an area ratio evaluating tool.
"Fig. 5" is a view for explaining a measurement method of a bond line thickness using a viscoelasticity measuring device.

### Description of Embodiments

### [Heat-Radiating Sheet]

The heat-radiating sheet of the present invention is such that when a heat cycle test of one cycle in which 3.2 mL of a heat-radiating grease having a viscosity at 25°C at a shear velocity of 10 s⁻¹ of 22 Pa s and a bond line thickness of 52 pm is sandwiched between a heat-radiating sheet of 180 mm × 100 mm arranged on an aluminum plate and a glass plate by a clamping force of 0.2 MPa per unit area, and after expanding the heat-radiating grease, the heat-radiating sheet is held at a temperature of -40°C for 30 minutes and then held at a temperature of 125°C for 30 minutes, is performed 100 cycles, an area ratio (S2/S1) of an area (S2) of the heat-radiating grease after performing the heat cycle test of 100 cycles to an area (S1) of the heat-radiating grease expanded before performing the heat cycle test is 1.0 to 2.0. Specifically, in the heat-radiating sheet of the present invention, in the heat cycle test using a glass plate as mentioned in the section of Examples as mentioned later, the area ratio (S2/S1) of the area (S2) of the heat-radiating grease after performing the heat cycle test of 100 cycles to the area (S1) of the heat-radiating grease expanded before performing the heat cycle test is 1.0 to 2.0. When the aforementioned area ratio (S2/S1) is larger than 2.0, at the time of allowing the heat-radiating grease layer to intervene between the heat-generating element and the heat-radiating sheet, there is a case where the pump-out phenomenon of the heat-radiating grease becomes remarkable. The viscosity value "22 Pa·s" at 25°C of the heat-radiating grease is typically one of values of viscosity at 25°C of the heat-radiating grease to be used. In addition, the bond line thickness value "52 pm" of the heat-radiating grease is typically one of values of bond line thicknesses of the heat-radiating grease to be used. By adjusting the aforementioned area ratio measured using the heat-radiating grease having such viscosity and bond line thickness so as to fall within the specified range, in the case of using a typical heat-radiating grease, the pump-out phenomenon can be effectively suppressed.

The bond line thickness can be measured using a viscoelasticity measuring device. The measurement method of the bond line thickness using a viscoelasticity measuring device is explained by reference to Fig. 5. A cylindrical measuring tool having a diameter of 8 mm and a disc-shaped measuring tool are installed in a viscoelasticity measuring device. Then, utilizing a function of the viscoelasticity measuring device to deform a sample in the compression direction, a cylindrical measuring tool 41 is pressed at a stress of 10 N against a disc-shaped measuring tool 42 as shown in Fig. 5(a). At this time, a gap between the cylindrical measuring tool 41 and the disc-shaped measuring tool 42 is set to zero. Subsequently, as shown in Fig. 5(b), the cylindrical measuring tool 41 is kept apart from the disc-shaped measuring tool 42 such that the gap between the cylindrical measuring tool 41 and the disc-shaped measuring tool 42 becomes 1 mm. Then, a heat-radiating grease 43 is arranged between the cylindrical measuring tool 41 and the disc-shaped measuring tool 42. As shown in Fig. 5(c), the cylindrical measuring tool 41 is again pressed at a stress of 10 N against the disc-shaped measuring tool 42. Since the heat-radiating grease 43 is present between the cylindrical measuring tool 41 and the disc-shaped measuring tool 42, the gap between the cylindrical measuring tool 41 and the disc-shaped measuring tool 42 becomes larger than zero. The gap between the cylindrical measuring tool 41 and the disc-shaped measuring tool 42 at this time is expressed as the bond line thickness.

For example, the heat-radiating sheet in which the aforementioned area ratio (S2/S 1) can be adjusted to 1.0 to 2.0 can be obtained by forming linear grooves intersecting each other on the surface of the heat-radiating sheet by means of embossing or the like. In adjusting the aforementioned area ratio (S2/S1), it is especially efficient to form linear grooves on the whole heat-radiating sheet. It may be considered that by forming the plural grooves entirely on the heat-radiating sheet, even if expansion or contraction occurs in the heat-radiating sheet or the like, the heat-radiating grease can be retained in the grooves, whereby the aforementioned area ratio (S2/S1) can be made small. In addition, it is preferred that a distance between the adjacent grooves to each other is 100 to 1,500 pm, a depth of the groove is 5 to 25 pm, and a width of the groove is 5 to 25 pm. In addition, the aforementioned area ratio (S2/S1) can be made small by shortening the distance between the adjacent grooves to each other, making the depth of the groove deep, or making the width of the groove large. The grooves may be formed on only one surface of the two main surfaces of the heat-radiating sheet, or the grooves may be formed on the both surfaces thereof.

### (Area Ratio (S2/S1))

When the heat-radiating grease is allowed to intervene between the heat-generating element and the heat-radiating sheet, from the viewpoint that the pump-out phenomenon of the heat-radiating grease can be suppressed more largely, an area ratio (S2/S1) of an area (S2) of the heat-radiating grease after performing the heat cycle test of 100 cycles to an area (S1) of the heat-radiating grease expanded before performing the heat cycle test is 1.0 to 2.0, preferably 1.0 to 1.7, more preferably 1.0 to 1.5, and still more preferably 1.0 to 1.3.

### (Surface Roughness of Heat-Radiating Sheet)

When the heat-radiating grease is allowed to intervene between the heat-generating element and the heat-radiating sheet, from the viewpoint that the pump-out phenomenon of the heat-radiating grease can be suppressed more largely, a surface roughness of the heat-radiating sheet of the present invention is preferably 1.2 to 3.5 pm, more preferably 1.5 to 3.2 pm, and still more preferably 2.0 to 3.0 µm in terms of an arithmetic average roughness (Ra). In addition, the surface roughness of the heat-radiating sheet of the present invention is preferably 10 to 25 pm, more preferably 14 to 23 pm, and still more preferably 17 to 23 pm in terms of a ten-point average roughness (Rz). The arithmetic average roughness (Ra) and the ten-point average roughness (Rz) are each a value measured in conformity with JIS B0601:2013.

As mentioned above, though the area ratio (S2/S 1) can be adjusted by, for example, physically adjusting the surface through groove formation or the like, other method may also be adopted. For example, the S2/S1 may be adjusted by chemically adjusting the surface state of the heat-radiating sheet. Specifically, there may be considered a method of modifying the surface with high compatibility with the heat-radiating grease.

### (Components of Heat-Radiating Sheet)

The components of the heat-radiating sheet of the present invention are not particularly limited so long as they are a component which is usually used for a heat-radiating sheet. For example, the heat-radiating sheet of the present invention can contain a resin binder and a filler having a high thermal conductivity.

### <Resin Binder>

The resin binder used for the heat-radiating sheet of the present invention is not particularly limited so long as it is a resin binder which is usually used for a heat-radiating sheet. Examples of the resin binder which is used for the heat-radiating sheet of the present invention include epoxy resins, silicone resins, acrylic resins, phenol resins, melamine resins, urea resins, unsaturated polyesters, fluorine resins, urethane resins, polyamides (for example, polyimide, polyamide-imide, and polyether imide), polyesters (for example, polybutylene terephthalate and polyethylene terephthalate), polyphenylene ethers, polyphenylene sulfides, wholly aromatic polyesters, polysulfones, liquid crystal polymers, polyether sulfones, polycarbonates, maleimide-modified resins, ABS resins, AAS (acrylonitrile-acrylic rubber/styrene) resins, and AES (acrylonitrile/ethylene/propylene/diene rubber-styrene) resins. These can be used either alone or in combination of two or more thereof. From the viewpoint of facilitating handling of the heat-radiating sheet and the viewpoint of more enhancing adhesion of the heat-radiating sheet, the resin binder is preferably a rubber or an elastomer. Of these, silicone resins are preferred from the viewpoint of heat resistance, weather resistance, electric insulation, and chemical stability.

From the viewpoint that ionic impurities as a cause of metal corrosion are not contained and that by-products are not formed after the reaction, the silicone resin which is used for the heat-radiating sheet of the present invention is preferably an addition reaction type silicone resin. The addition reaction type silicone resin is one resulting from curing through a hydrosilylation reaction between an alkenyl group and a hydrogen atom bound to a silicon atom by using a platinum compound as a catalyst. Examples of the addition reaction type silicone resin include a trade name "LR3303-20A/B", manufactured by Wacker Asahikasei Silicone Co., Ltd.

### <Filler>

The filler used for the heat-radiating sheet of the present invention is not particularly limited so long as it is a filler which is usually used for a heat-radiating sheet. Examples of the filler used for the heat-radiating sheet of the present invention include an inorganic filler and a metal-based filler. Examples of the inorganic filler include zinc oxide, alumina, boron nitride, aluminum nitride, silicon carbide, and silicon nitride. Examples of the metal-based filler include aluminum, silver, and copper. These can be used either alone or in combination of two or more thereof. Of these, an inorganic filler is preferred from the viewpoint of electric insulation. Among the inorganic fillers, boron nitride is more preferred from the viewpoint of thermal conductivity and chemical stability. In addition, since the boron nitride has anisotropy in the thermal conductivity, a massive boron nitride particle in which the anisotropy of thermal conductivity is suppressed is still more preferred. The massive boron nitride particle is a particle resulting from massively coagulating flaky particles of hexagonal boron nitride.

An average particle diameter of the filler is preferably 8 to 90 pm. When the average particle diameter of the filler is 8 pm or more, the content of the filler can be made high. On the other hand, when the average particle diameter of the filler is 90 pm or less, the heat-radiating sheet can be made thin. From such viewpoint, the average particle diameter of the filler is more preferably 20 to 70 pm, still more preferably 25 to 50 pm, and especially preferably 25 to 45 pm. The average particle diameter of the filler can be, for example, measured using a laser diffraction scattering particle size analyzer (LS-13 320), manufactured by Beckman-Coulter, Inc. As the average particle diameter of the filler, one measured without applying a homogenizer thereto before the measurement treatment can be adopted. The obtained average particle diameter is, for example, an average particle diameter in terms of a volume statistics value.

The content of the filler relative to 100% by volume of the total of the resin binder and the filler is preferably 30 to 85% by volume, and more preferably 40 to 80% by volume. In the case where the content of the filler is 30% by volume or more, the thermal conductivity of the heat-radiating sheet is improved, and a sufficient heat-radiating performance is readily obtained. In addition, in the case where the content of the filler is 85% by volume or less, the matter that the voids are liable to be formed at the time of molding the heat-radiating sheet can be suppressed, and the insulation and mechanical strength of the heat-radiating sheet can be enhanced.

### <Reinforcing Layer>

The heat-radiating sheet of the present invention may include a reinforcing layer. The reinforcing layer takes a role to further improve the mechanical strength of the heat-radiating sheet, and moreover, when the heat-radiating sheet is compressed in the thickness direction, there is also brought an effect for suppressing elongation of the heat-radiating sheet to the planar direction, thereby securing the insulation. Examples of the reinforcing layer include a glass cloth; an alumina cloth; a resin film made of polyester, polyamide, polyimide, polycarbonate, acrylic resin, etc.; a cloth fiber mesh cloth made of cotton, hemp, aramid fiber, cellulose fiber, nylon fiber, polyolefin fiber, etc.; a nonwoven fabric made of aramid fiber, cellulose fiber, nylon fiber, polyolefin fiber, etc.; a metal fiber mesh cloth made of stainless steel, copper, aluminum, etc.; and a metal foil made of copper, nickel, aluminum, etc. These can be used either alone or in combination of two or more thereof. Of these, a glass cloth is preferred from the viewpoint of thermal conductivity, insulation and costs.

In the case of using a glass cloth as the reinforcing layer, a generally marketed glass cloth having openings can be used. From the viewpoint of thermal conductivity, a thickness of the glass cloth is preferably 10 pm to 150 pm, more preferably 20 to 90 pm, and still more preferably 30 to 60 pm. In the case where the thickness of the glass cloth is 10 pm or more, the glass cloth can be suppressed from breakage at the time of handling. On the other hand, in the case where the thickness of the glass cloth is 150 pm or less, a lowering of the thermal conductivity of the heat-radiating sheet owing to the glass cloth can be suppressed. Among marketed glass cloths, there are ones having a fiber diameter of 4 to 9 pm, and these can be used for the heat-radiating sheet 1. In addition, a tensile strength of the glass cloth is, for example, 100 to 1,000 N/25 mm. In addition, a length of one side of the opening of the glass cloth is preferably 0.1 to 1.0 mm from the viewpoint of balancing between the thermal conductivity and the strength. Examples of the glass cloth which can be used for the heat-radiating sheet 1 include a trade name "H25 F104", manufactured by Unitika Ltd.

In the case of using the reinforcing layer, the heat-radiating sheet may be produced by applying a composition for heat-radiating sheet on both surfaces of the reinforcing layer such that the reinforcing layer is arranged in the center in the thickness direction of the heat-radiating sheet, or the heat-radiating sheet may be produced by applying a composition for heat-radiating sheet on one surface of the reinforcing layer.

The heat-radiating sheet of the present invention may contain other component than the resin binder, the filler, and the reinforcing layer. Examples of the other component include an additive, a flame retarder, a silicone oil, a silane material, a silane coupling agent, a platinum catalyst, a curing agent, and a coloring agent. The content of the other component in 100% by volume of the volume of the heat-radiating sheet is, for example, 5% by volume or less, preferably 3% by volume or less, and more preferably 1% by volume or less.

### <Base Material Resin Layer>

The heat-radiating sheet of the present invention may be provided with a base material resin layer. The base material resin layer takes a role to further improve the heat resistance of the heat-radiating sheet. In this case, the heat-radiating sheet of the present invention includes a resin composition layer containing the aforementioned resin binder and filler and a base material resin layer adjacent to this resin composition layer. Then, it is preferred that one surface of the resin composition layer is a surface in which the aforementioned area ratio (S2/S1) is 1.0 to 2.0, and the base material resin layer is arranged on the other surface of the resin composition layer. In addition, the resin composition layer may include the aforementioned reinforcing layer.

The base material resin layer preferably contains a resin having a glass transition point of 200°C or higher. When the glass transition point is 200°C or higher, sufficient heat resistance is obtained, and the insulation or thermal conductivity of the laminate can be maintained favorable. The base material resin layer may be a layer formed of a coating film or may be formed of a film.

Examples of the resin constituting the base material resin layer include a polyimide, a polyamide-imide, a polyamide (in particular, an aromatic polyamide), a polyether sulfone, a polyether imide, polyethylene naphthalate, polytetrafluoroethylene (PTFE), and a tetrafluoroethylene/perfluoroalkyl vinyl ether copolymer (PFA). Above all, a polyimide is preferred. In addition, these resins can be used either alone or in combination of several kinds thereof.

Although the content of the resin in the base material resin layer is not particularly limited, a lower limit thereof is preferably 78% by volume or more, more preferably 80% by volume or more, and still more preferably 82% by volume or more. An upper limit thereof is preferably 92% by volume or less, more preferably 90% by volume or less, and still more preferably 88% by volume or less.

It is preferred that the base material resin layer contains an inorganic filler. When the base material resin layer contains an inorganic filler, the insulation, thermal conductivity, peel strength, and so on can be improved. In particular, it may be assumed that the rise of the peel strength resides in the matter that unevennesses are formed at an interface between the base material resin layer and the resin composition layer owing to the inorganic filler, whereby an anchor effect is produced. As the inorganic filler, the same materials as those in the aforementioned filler can be used.

Although the content of the inorganic filler in the base material resin layer is not particularly limited, a lower limit thereof is preferably 8% by volume or more, more preferably 10% by volume or more, and still more preferably 12% by volume or more. An upper limit thereof is preferably 22% by volume or less, more preferably 20% by volume or less, and still more preferably 18% by volume or less.

In the base material resin layer, the aforementioned other component may be contained in a small amount, and impurities may be contained in small amounts. In the base material resin layer, the total content of the aforementioned resin and inorganic filler is preferably 90% by volume or more, more preferably 95% by volume or more, and still more preferably 97% by volume or more.

From the viewpoint of insulation, thermal conductivity, and processability, the thickness of the base material resin layer is preferably the following range. A lower limit thereof is preferably 0.010 mm or more. By setting the thickness of the base material resin layer to 0.010 mm or more, not only the insulation can be further improved, but also the processability can be improved, too. The thickness of the base material resin layer is more preferably 0.012 mm or more, and still more preferably 0.015 mm or more. An upper limit thereof is preferably 0.100 mm or less, more preferably 0.070 mm or less, and still more preferably 0.050 mm or less.

The film serving as the base material resin layer can be fabricated in conformity with a known film fabricating method. In addition, products which are on sale in the market may be acquired and used.

In the case of the heat-radiating sheet provided with the base material resin layer, the resin composition (composition for heat-radiating sheet) is applied on a base material sheet serving as the base material resin layer. As the application method on the base material sheet, a conventionally known method, for example, a coater method, a doctor blade method, an extrusion molding method, an injection molding method, and a press molding method, can be adopted. Even in the case of the heat-radiating sheet provided with the base material resin layer, the composition for heat-radiating sheet may be applied on both surfaces of the base material resin layer such that the base material resin layer is arranged in the center in the thickness direction of the heat-radiating sheet, or the composition for heat-radiating sheet may be applied on only one surface thereof,

### <Form of Heat-Radiating Sheet>

The form of the heat-radiating sheet of the present invention is not particularly limited. The heat-radiating sheet of the present invention may be any of a sheet product and a roll product.

### [Heat-Radiating Sheet Laminate]

As shown in Fig. 1, a heat-radiating sheet laminate 10 of an embodiment of the present invention includes a heat-radiating sheet 1 of an embodiment of the present invention and a heat-radiating grease layer 11 formed on a surface of the heat-radiating sheet 1. According to this, not only the contact thermal resistance between a heat-generating element 21 and the heat-radiating sheet 1 can be reduced, but also the pump-out phenomenon of the heat-radiating grease can be suppressed. The surface of the heat-radiating sheet 1 on which the heat-radiating grease layer 11 is formed has a surface state in which the area ratio (S2/S1) falls within the aforementioned range.

### (Heat-Radiating Grease)

The heat-radiating grease 11 which is used for the heat-radiating sheet laminate 10 of an embodiment of the present invention is not particularly limited so long as it is a heat-radiating grease which is usually used as a heat-radiating material. Examples of the heat-radiating grease is one prepared by kneading a liquid polymer and a filler in a paste-like form. As the filler, for example, the same materials as those in the aforementioned filler used for the heat-radiating sheet of the present invention can be used. Of these, from the viewpoint of electric insulation, inorganic fillers are preferred, and among the inorganic fillers, alumina is more preferred from the viewpoint of thermal conductivity and insulation as well as costs. In addition, though the shape of the alumina may be any of a spherical shape, a granular shape, a platy shape, and an amorphous shape, it is especially preferably a spherical shape from the viewpoint of fluidity. Examples of the liquid polymer include hydrocarbon oils, such as a polyolefin, an alkyl aromatic compound, and an alicyclic compound; polyethers, such as a polyglycol and a phenyl ether; esters, such as a diester and a polyol ester; phosphorus compounds, such as an aromatic phosphoric acid ester; silicon compounds, such as a silicone; halogen compounds, such as a fluorinated polyether; mineral oils; fluorosilicones; acrylic reins; and urethane resins. Of these liquid polymers, silicones are preferred from the viewpoint of heat resistance, weather resistance, electric insulation, and chemical stability.

As mentioned above, in the present invention, though the kind of the heat-radiating grease is not particularly limited, a value of the viscosity at 25°C of a usual heat-radiating grease is 10 to 400 Pa·s, and in the case of using a usual heat-radiating grease having such a viscosity, the pump-out phenomenon can be more effectively suppressed. In particular, the heat-radiating sheet of the present invention is effective for a heat-radiating grease having a low viscosity. What the viscosity is lower is preferred from the viewpoint of easiness of handling of the heat-radiating grease, etc., but there is involved such a problem that the pump-out phenomenon is liable to occur. In accordance with the heat-radiating sheet of the present invention, even if a heat-radiating grease having a low viscosity is used, the pump-out phenomenon can be suppressed from occurring. The heat-radiating grease having a low viscosity as referred to herein means a heat-radiating grease having a value of viscosity at 25°C of 300 Pa s or less.

As mentioned above, in the present invention, though the kind of the heat-radiating grease is not particularly limited, a value of the bond line thickness of a usual heat-radiating grease is 10 to 120 pm, and in the case of using a usual heat-radiating grease having such a bond line thickness, the pump-out phenomenon can be more effectively suppressed. In particular, the heat-radiating sheet of the present invention is effective for a heat-radiating grease having a small bond line thickness. What the bond line thickness is smaller is preferred from the viewpoint of thermal resistance, etc., but there is involved such a problem that the pump-out phenomenon is liable to occur. In accordance with the heat-radiating sheet of the present invention, even if a heat-radiating grease having a small bond line thickness is used, the pump-out phenomenon can be suppressed from occurring. The heat-radiating grease having a small bond line thickness as referred to herein means a heat-radiating grease having a value of bond line thickness of 60 pm or less.

The use amount of the heat-radiating grease 11 which is used for the heat-radiating sheet laminate 10 of an embodiment of the present invention may be 1.5 to 8.0 mL, may be 2.3 to 4.5 mL, or may be 2.6 to 3.8 mL per 180 mm × 100 mm of the heat-radiating sheet so long as the shape of the groove, or the like falls within the aforementioned preferred range. In addition, so long as a usual heat-radiating grease has a viscosity at 25°C at a shear velocity of 10 s⁻¹ in a range of 15 to 1,000 Pa s, such is effective, and in order to allow it to fall within the aforementioned range, the viscosity may be adjusted by, for example, a method of vacuum defoaming/mixing.

### (Modification Example of Heat-Radiating Sheet Laminate of Embodiment of the Present Invention)

The heat-radiating sheet laminate of an embodiment of the present invention can be modified as follows.

In the heat-radiating sheet laminate 10 of an embodiment of the present invention as shown in Fig. 1, the heat-radiating grease 11 is arranged on only one surface side of the heat-radiating sheet 1. But, as in a heat-radiating sheet laminate 10A shown in Fig. 2, the heat-radiating grease 11 and 12 may be arranged on the both sides of the heat-radiating sheet 1. According to this, the contact thermal resistance between the heat-radiating sheet 1 and a heat sink 30 can also be reduced. In this case, the both surfaces of the heat-radiating sheet 1 have a surface state such that the aforementioned area ratio (S2/S1) of the heat-radiating grease falls within the aforementioned range.

### [Laminate]

As shown in Fig. 1, a structure 20 of an embodiment of the present invention includes the heat-radiating sheet 1 of an embodiment of the present invention, the heat-generating element 21 placed on the heat-radiating sheet 1, and the heat-radiating grease 11 intervening between the heat-generating sheet 1 and the heat-generating element 21. According to this, not only the contact thermal resistance between the heat-generating element 21 and the heat-radiating sheet 1 can be reduced, but also the pump-out phenomenon of the heat-radiating grease 11 can be suppressed. The surface of the heat-radiating sheet 1 having the heat-radiating grease 11 arranged therein has a surface state such that the aforementioned area ratio (S2/S1) of the heat-radiating grease falls within the aforementioned range. For the heat-radiating grease 11, the same materials as those in the aforementioned heat-radiating grease used for the aforementioned heat-radiating sheet laminate can be used.

### (Heat-Generating Element)

Examples of the heat-generating element include power devices, transistors, thyristors, CPUs, IGBT modules, and diodes.

### (Modification Examples of Structure of Embodiment of the Present Invention)

The structure of an embodiment of the present invention can be modified as follows.

### <Modification Example 1>

In the structure 20 of an embodiment of the present invention as shown in Fig. 1, the heat-radiating grease 11 is arranged on only one surface side of the heat-radiating sheet 1. But, as in a structure 20A shown in Fig. 2, the heat-radiating grease 11 and 12 may be arranged on the both sides of the heat-radiating sheet 1. According to this, the contact thermal resistance between the heat-radiating sheet 1 and the heat sink 30 can be reduced, too. In this case, the both surfaces of the heat-radiating sheet 1 have a surface state such that the aforementioned area ratio (S2/S 1) of the heat-radiating grease falls within the aforementioned range.

### <Modification Example 2>

In place of the heat-generating element, a substrate having a heat-generating element mounted therein may be placed on the heat-radiating sheet.

### [Heat-Radiating Treatment Method of Heat-Generating Element]

A heat-radiating treatment method of a heat-generating element of the present invention includes a step of applying the heat-radiating sheet of the present invention, which has a first surface and a second surface on the opposite side to the first surface, with a heat-radiating grease on at least one surface of the first surface and the second surface; and a step of arranging a heat-generating element on the surface of the heat-radiating sheet, on which the heat-radiating grease has been applied. According to this, not only the contact thermal resistance between the heat-generating element and the heat-radiating sheet can be reduced, but also the pump-out phenomenon of the heat-radiating grease can be suppressed. For the application with the heat-radiating grease, for example, an auto dispense or screen printing method is adopted.

The foregoing heat-radiating sheet laminate 10 and structure 20 of an embodiment of the present invention and modified examples 10A and 20A thereof are each merely one mode and do not limit the heat-radiating sheet laminate and structure of the present invention.

### Examples

The present invention is hereunder described in detail by reference to Examples and Comparative Example. It should be construed that the present invention is not limited to the following Examples.

The heat-radiating sheets of the Examples and Comparative Example were subjected to the following evaluations.

### (Thickness of Heat-Radiating Sheet)

The thickness of the heat-radiating sheet was measured with a thickness gauge (Model No.: 547-301, manufactured by Mitutoyo Corporation) with respect to ten optional places, and an average value thereof was expressed as the thickness of the heat-radiating sheet.

### (Surface Roughness of Heat-Radiating Sheet)

The surface roughness of the heat-radiating sheet was measured with a confocal microscope (trade name: LT·9010M, manufactured by Keyence Corporation) under conditions of a measured length of 10,000 pm, a measured pitch of 10 pm, and a measured velocity of 500 pm in conformity with JIS B0601:2013.

### (Measurement of Area Ratio (S2/S1) of Heat-Radiating Grease)

A heat cycle test was performed using an area ratio evaluating tool 100 shown in Fig. 3, to examine the aforementioned area ratio (S2/S1) of the heat-radiating grease. First, the area ratio evaluating tool 100 is described by reference to Fig. 3.

The area ratio evaluating tool 100 includes an aluminum plate 110 on which a heat-radiating sheet 200 is placed; a transparent glass plate 120 sandwiching the heat-radiating sheet 200 and a heat-radiating grease 300 to be dropped on the heat-radiating sheet in combination with the aluminum plate 110; a transparent resin-made glass plate fixing plate 130 fixing the glass plate 120; and bolts 140 and nuts 150 used for fastening a gap between the aluminum plate 110 and the glass plate 120. The aluminum plate 110 is provided with holes 111 for passing screw parts 141 of the bolts 140 therethrough. The glass plate fixing plate 130 is provided with hollow parts 131 for fitting the glass plate 120 and holes 132 for passing the screw parts 141 of the bolts 140 therethrough. The depth of the hollow part 131 is slightly smaller than the thickness of the glass plate 120.

For the aluminum plate 110, an aluminum plate having a quality of material of A-5052 was used. The size of the aluminum plate 110 was 180 mm × 100 mm × 10 mm. In addition, the size of the glass plate 120 was 70 mm × 55 mm × 10 mm. Furthermore, a vinyl chloride-based resin was used for the glass plate fixing plate 130. The size of the glass plate fixing plate 130 was 180 mm × 100 mm × 30 mmmm.

Next, the measurement method of the area ratio is described. The heat-radiating sheet 200 provided with holes 210 for passing the screw parts 141 of the bolt 140 therethrough and having a size of 180 mm × 100 m was placed on the aluminum plate 110. Then, 3.2 mL of the heat-radiating grease 300 was dropped on the heat-radiating sheet 110 placed on the aluminum plate 110. A position of the heat-radiating sheet 200 at which the heat-radiating grease 300 was dropped was a position corresponding to the center of the glass plate 120 to be placed on the heat-radiating grease 300.

Subsequently, the glass plate fixing plate 130 having the glass plate 120 fitted therein was placed on the heat-radiating sheet 200 on which the heat-radiating grease 300 had been dropped. According to this, the heat-radiating grease 300 was sandwiched by the heat-radiating sheet 200 and the glass plate 120. Then, the screw parts 141 of the bolts 140 were inserted into the holes 111 of the aluminum plate 110, the holes 210 of the heat-radiating sheet 200, and the holes 131 of the glass plate fixing plate 130, respectively, and then, the gap between the aluminum plate 110 and the glass plate 120 was fasten using the nuts 150. A fastening force per unit area of the gap between the aluminum plate 110 and the glass plate 120 was 0.2 MPa. As shown in Fig. 4, the spread state of the heat-radiating grease 300 could be seen through the glass plate 120 and the glass plate fixing plate 130. Then, the heat-radiating grease 300 was photographed through the glass plate 120 and the glass plate fixing plate 130, and an area (S1) of the spread heat-radiating grease 300 was measured from the photographed image. In Fig. 4, an area of the heat-radiating grease 300 sandwiched between the glass plate 120 and the heat-radiating sheet is corresponding to the area (S1) of the heat-radiating grease in the heat-radiating sheet of the present invention.

The area ratio evaluating tool 100 having the heat-radiating sheet 200 and the heat-radiating grease 300 sandwiched therein was made horizontal to perform the heat cycle test. The heat cycle test in which the operation of holding at a temperature of -40°C for 30 minutes and then holding at a temperature of 125°C for 30 minutes was one cycle was performed 100 cycles. With respect to the area ratio evaluating tool 100 after performing the heat cycle test of 100 cycles, the heat-radiating grease 300 was photographed through the glass plate 120 and the glass plate-fixing plate 130, an area (S2) of the spread heat-radiating grease 300 was measured from the photographed image. In Fig. 4, an area of the heat-radiating grease 300 sandwiched between the glass plate 120 and the heat-radiating sheet after the heat cycle test of 100 cycles is corresponding to the area (S2) of the heat-radiating grease in the heat-radiating sheet of the present invention. Then, the area ratio (S2/S1) of the area (S2) of the heat-radiating grease after the heat cycle test of 100 cycles to the area (S1) of the heat-radiating grease before the heat cycle test was calculated. For the area ratio evaluating test, the following heat-radiating grease was used.

Heat-radiating grease: Trade name: GFC-PF3, manufactured by Denka Company Limited, viscosity at 25°C at a shear velocity of 10 s⁻¹: 22 Pa·s, bond line thickness: 52 pm, dropped amount: 3.2 mL

### (Heat Cycle Test Using Heat-Generating Element)

In the area ratio evaluating tool 100, a power module assembly (PM-Assy) (Model No.: TO-3P Shape Transistor, manufactured by Toshiba Corporation) was arranged in place of the glass plate 120 and the glass plate fixing plate 130, and the heat cycle test was performed. In this heat cycle test, 0.16 mL of the heat-radiating grease was dropped on the heat-radiating sheet placed on an aluminum plate (Model No.: 40CH104, manufactured by Ryosan Company, Limited). A position of the heat-radiating sheet at which the heat-radiating grease was dropped was a position corresponding to the center of the PM-Assy to be placed on the heat-radiating grease. Then, the PM-Assy was placed on the heat-radiating sheet on which the heat-radiating greased had been dropped. According to this, the heat-radiating grease was sandwiched by the heat-radiating sheet and the PM-Assy. Then, the screw parts of the bolts were inserted into the holes of the aluminum plate, the holes of the heat-radiating sheet, and the holes of the PM-Assy, respectively, and then, the gap between the aluminum plate and the PM-Assy was fasten using the nuts. A fastening force per unit area of the gap between the aluminum plate and the PM-Assy was 1.0 MPa. At this stage, after confirming that the heat-radiating grease did not flow out from the gap between the PM-Assy and the heat-radiating sheet, the PM-Assy was made horizontal to perform the heat cycle test. The heat cycle test in which the operation of holding at a temperature of -40°C for 30 minutes and the holding at a temperature of 125°C for 30 minutes was one cycle was performed 100 cycles. Then, after the heat cycle test of 100 cycles, the presence or absence of flowing out of the heat-radiating grease from the gap between the PM-Assy and the heat-radiating sheet was confirmed.

The heat-radiating sheets of the Examples and Comparative Example were fabricated in the following manner.

### [Example 1]

### (Fabrication of Hexagonal Boron Nitride)

Boric acid, melamine, and calcium carbonate (all being a special grade reagent) were mixed in a proportion of 70/50/5 in terms of a mass ratio; the temperature was raised in a nitrogen gas atmosphere from room temperature to 1,400°C over 1 hour; after retaining at 1,400°C for 3 hours, the temperature was raised to 1,900°C over 4 hours; and after retaining at 1,900°C for 2 hours, cooling to room temperature was performed to produce hexagonal boron nitride. After crushing this, the resultant was pulverized and sieved to fabricate a massive boron nitride particle. An average particle diameter of the fabricated massive boron nitride particle was 50 µm.

### (Fabrication of Composition for Heat-Radiating Sheet)

To 110 g of a silicone resin (Model No.: LR3303-20A, manufactured by Wacker Asahikasei Silicone Co., Ltd.) and 110 g of a silicone resin (Model No.: LR3303-20B, manufactured by Wacker Asahikasei Silicone Co., Ltd.), 650 g of the fabricated massive boron nitride particle was added; then, toluene was added as a viscosity modifier such that the solid component concentration was 60 wt%; and the contents were mixed with a stirrer (trade name: Three-One Motor, manufactured by HEIDON Inc.) using a turbine type stirring blade for 15 hours, to fabricate a composition for heat-radiating sheet.

### (Fabrication of Heat-Radiating Sheet Precursor Sheet)

On a Teflon (registered trademark) sheet, the aforementioned composition for heat-radiating sheet was applied in a thickness of 0.5 mm per surface by using a comma coater and dried at 75°C for 5 minutes. Thereafter, using a flat plate pressing machine (manufactured by Yanase Seisakusho Co., Ltd.), pressing was performed for 10 minutes under conditions at a temperature of 120°C and a pressure of 50 kgf/cm², to fabricate a sheet having a thickness of 0.30 mm. Subsequently, secondary heating was performed at atmospheric pressure at a temperature of 150°C for 4 hours, to fabricate a heat-radiating sheet precursor sheet.

### (Roughening Treatment of Heat-Radiating Sheet Precursor Sheet)

A transfer sheet, on the surface of which plural first projections extending in a first direction and plural second projections extending in a second direction different from the first direction and intersecting the first grooves were provided, was prepared. In the transfer sheet, a distance between the adjacent first projections to each other and a distance between the adjacent second projections to each other were each 1.0 mm. In addition, a width of each of the first projections and the second projections was 10 pm. Furthermore, a height of each of the first projections and the second projections was 20 pm. In addition, an angle formed by the first direction and the second direction was 90°. Furthermore, the first projections and the second projections were each a linearly extending projection. In addition, a shape of the cross-section of each of the first projections and the second projections was quadrilateral.

The aforementioned transfer sheet was placed on the heat-radiating sheet precursor sheet, and then, using a flat plate pressing machine (manufactured by Yanase Seisakusho Co., Ltd.), pressing was performed for 30 minutes under conditions at a temperature of 165°C and a pressure of 150 kgf/cm², to form grooves on the surface of the heat-radiating sheet precursor sheet. There was thus fabricated a heat-radiating sheet of Example 1.

### [Example 2]

A heat-radiating sheet of Example 2 was fabricated in the same manner as in Example 1, except that the pressure of the flat pressing machine at the time of forming grooves on the surface of the heat-radiating sheet precursor sheet was changed from 150 kgf/cm² to 220 kgf/cm².

### [Example 3]

A heat-radiating sheet of Example 3 was fabricated in the same manner as in Example 1, except that the pressure of the flat pressing machine at the time of forming grooves on the surface of the heat-radiating sheet precursor sheet was changed from 150 kgf/cm² to 50 kgf/cm².

### [Example 4]

On the occasion of fabricating the heat-radiating sheet precursor sheet, a polyimide film (trade name: Kapton 100H, manufactured by "DU PONT-TORAY CO., LTD., thickness: 0.026 mm) was arranged as a base material resin layer on a Teflon (registered trademark) sheet, and then, the aforementioned composition for heat-radiating sheet was applied in a thickness of 0.2 mm on the polyimide film by using a comma coater and dried at 75°C for 5 minutes, to apply the composition for heat-radiating sheet on one surface of the polyimide film. Subsequently, the resultant was turned over such that the polyimide film was located on the upper side; the composition for heat-radiating sheet was applied in a thickness of 0.2 mm on the polyimide film by using a comma coater and then dried at 75°C for 5 minutes, to fabricate a sheet of the composition for heat-radiating sheet having the composition for heat-radiating sheet on the both surfaces thereof. Other than that, the same method as in Example 1 was performed to fabricate a heat-radiating sheet of Example 4.

### [Comparative Example 1]

A heat-radiating sheet of Comparative Example 1 was fabricated in the same manner as in Example 1, except that no groove was formed on the surface of the heat-radiating sheet precursor sheet.

The evaluation results of the heat-radiating sheets of Examples 1 to 3 and Comparative Example 1 are shown in Table 1.

**Table 1**

| Thickness | | Unit | Example 1 | Example 2 | Example 3 | Example 4 | Comparative Example 1 |
|---|---|---|---|---|---|---|---|
| | | pm | 0.301 | 0.312 | 0.304 | 0.237 | 0.299 |
| Surface roughness | Ra | µm | 1.8 | 2.7 | 1.5 | 1.9 | 0.9 |
| | Rz | µm | 10 | 19 | 12 | 19 | 9.2 |
| | Area (S1) of heat-radiating grease before heat cycle test | cm² | 36.0 | 33.0 | 37.0 | 34.5 | 34.2 |
| Heat cycle test using glass plate | Area (S2) of heat-radiating grease after heat cycle test of 100 cycles | cm² | 51.2 | 39.5 | 62.3 | 49.5 | 76.0 |
| Heat cycle test using heat-generating element | Area ratio (S2/S1) | - | 1.42 | 1.20 | 1.68 | 1.43 | 2.22 |
| | Presence or absence of flowing out of heat-radiating grease | - | No | No | No | No | Yes |

From the foregoing evaluation results, it was noted that when the heat-radiating sheet having an area ratio (S2/S1) of 1.0 to 2.0 is used for mounting of the heat-generating element, the pump-out phenomenon is suppressed. On the other hand, it was noted that when the heat-radiating sheet having the aforementioned area ratio (S2/S1) of larger than 2.0 is used for mounting of the heat-generating element, the pump-out phenomenon remarkably occurs.

In addition, the dielectric breakdown voltage of Examples 1 and 4 was evaluated by a short-time breakdown test (at room temperature: 23°C) in conformity with JIS C2110. As a result, in Examples 4, the dielectric breakdown voltage was higher by about 3 kV.

### Reference Signs List

1, 200: Heat-radiating sheet
10, 10A: Heat-radiating sheet laminate
11, 11A, 12, 43, 300: Heat-radiating grease
20, 20A: Structure
21: Heat-generating element
30: Heat sink
41: Cylindrical measuring tool
42: Disc-shaped measuring tool
100: Area ratio evaluating tool
110: Aluminum plate
120: Glass plate
130: Glass plate fixing plate
140: Bolt
150: Nut

## Claims

1. A heat-radiating sheet (1, 200), wherein
when a heat cycle test of one cycle in which 3.2 mL of a heat-radiating grease (11, 11A, 12, 43, 300) having a viscosity at 25°C at a shear velocity of 10 s⁻¹ of 22 Pa s and a bond line thickness (BLT) of 52 pm is sandwiched between a heat-radiating sheet of 180 mm × 100 mm arranged on an aluminum plate (110) and a glass plate (120) by a clamping force of 0.2 MPa per unit area, and after expanding the heat-radiating grease, the heat-radiating sheet is held at a temperature of -40°C for 30 minutes and then held at a temperature of 125°C for 30 minutes, is performed 100 cycles,
an area ratio (S2/S1) of an area (S2) of the heat-radiating grease after performing the heat cycle test of 100 cycles to an area (S1) of the heat-radiating grease expanded before performing the heat cycle test is 1.0 to 2.0.

2. The heat-radiating sheet according to claim 1, wherein the area ratio (S2/S1) is 1.0 to 1.7.

3. A heat-radiating sheet laminate (10, 10A) comprising
the heat-radiating sheet (1,200) according to claim 1 or 2, which has a first surface and a second surface on the opposite side to the first surface; and
a heat-radiating grease (11, 11A, 12, 43, 300) layer formed on at least one surface of the first surface and the second surface of the heat-radiating sheet.

4. A structure (20,20A) comprising
the heat-radiating sheet (1,200) according to claim 1 or 2,
a heat-generating element (21) placed on the heat-radiating sheet, and
a heat-radiating grease (11, 11A, 12, 43, 300) intervening between the heat-radiating sheet and the heat-generating element.

5. A heat-radiating treatment method of a heat-generating element (21) comprising
a step of applying the heat-radiating sheet (1,200) according to claim 1 or 2, which has a first surface and a second surface on the opposite side to the first surface, with a heat-radiating grease (11, 11A, 12, 43, 300) on at least one surface of the first surface and the second surface; and
a step of arranging a heat-generating element (21) on the surface of the heat-radiating sheet, on which the heat-radiating grease has been applied.

## Patentansprüche

1. Eine wärmeabstrahlende Platte (1, 200), wobei,
wenn ein Wärmezyklustest von einem Zyklus, bei dem 3,2 mL eines wärmeabstrahlenden Fetts (11, 11A, 12, 43, 300) mit einer Viskosität bei 25°C bei einer Schergeschwindigkeit von 10 s⁻¹ von 22 Pa s und einer Bondliniendicke (BLT) von 52 µm zwischen eine wärmeabstrahlende Platte von 180 mm × 100 mm, die auf einer Aluminiumplatte (110) und einer Glasplatte (120) angeordnet ist, mit einer Klemmkraft von 0,2 MPa pro Einheitsfläche sandwichartig eingefügt werden, und bei dem nach dem Ausdehnen des wärmeabstrahlenden Fettes die wärmeabstrahlende Platte 30 Minuten lang bei einer Temperatur von -40 °C gehalten und dann 30 Minuten lang bei einer Temperatur von 125 °C gehalten wird, mit 100 Zyklen durchgeführt wird,
ein Flächenverhältnis (S2/S 1) einer Fläche (S2) des wärmeabstrahlenden Fettes nach Durchführung des Wärmezyklustests von 100 Zyklen zu einer Fläche (S1) des vor Durchführung des Wärmezyklustests ausgedehnten wärmeabstrahlenden Fettes 1,0 bis 2,0 beträgt.

2. Wärmeabstrahlende Platte nach Anspruch 1, wobei das Flächenverhältnis (S2/S1) 1,0 bis 1,7 beträgt.

3. Wärmeabstrahlendes Plattenlaminat (10, 10A), umfassend
die wärmeabstrahlende Platte (1, 200) nach Anspruch 1 oder 2, die eine erste Oberfläche und eine zweite Oberfläche auf der der ersten Oberfläche gegenüberliegenden Seite aufweist; und
eine wärmeabstrahlende Fett-(11, 11A, 12, 43, 300)-Schicht, die auf mindestens einer Oberfläche der ersten Oberfläche und der zweiten Oberfläche der wärmeabstrahlenden Platte ausgebildet ist.

4. Struktur (20, 20A), umfassend
die wärmeabstrahlende Platte (1, 200) nach Anspruch 1 oder 2,
ein wärmeerzeugendes Element (21), das auf der wärmeabstrahlenden Platte angeordnet ist, und
ein wärmeabstrahlendes Fett (11, 11A, 12, 43, 300), das zwischen der wärmeabstrahlenden Platte und dem wärmeerzeugenden Element liegt.

5. Verfahren zur Wärmestrahlungsbehandlung eines wärmeerzeugenden Elements (21), umfassend
einen Schritt des Überziehens der wärmeabstrahlenden Platte (1, 200) nach Anspruch 1 oder 2, die eine erste Oberfläche und eine zweite Oberfläche auf der der ersten Oberfläche gegenüberliegenden Seite aufweist, mit einem wärmeabstrahlenden Fett (11, 11A, 12, 43, 300) auf mindestens einer Oberfläche der ersten Oberfläche und der zweiten Oberfläche; und
einen Schritt des Anordnens eines wärmeerzeugenden Elements (21) auf der Oberfläche der wärmeabstrahlenden Platte, die mit dem wärmeabstrahlenden Fett überzogen worden ist.

## Revendications

1. Feuille à rayonnement thermique (1, 200), dans laquelle
lorsqu'un essai de cycle thermique d'un cycle dans lequel 3,2 mL d'une graisse à rayonnement thermique (11, 11A, 12, 43, 300) ayant une viscosité à 25°C à une vitesse de cisaillement de 10 s⁻¹ de 22 Pa·s et une épaisseur de ligne de liaison (BLT) de 52 µm sont prises en sandwich entre une feuille à rayonnement thermique de 180 mm × 100 mm disposée sur une plaque d'aluminium (110) et une plaque de verre (120) par une force de serrage de 0.2 MPa par unité de surface, et après expansion de la graisse à rayonnement thermique, la feuille à rayonnement thermique est maintenue à une température de -40°C pendant 30 minutes, puis maintenue à une température de 125°C pendant 30 minutes, est effectué en 100 cycles,
un rapport de surface (S2/S1) entre une surface (S2) de la graisse à rayonnement thermique après l'exécution de l'essai de cycle thermique de 100 cycles et une surface (S1) de la graisse à rayonnement thermique dilatée avant l'exécution de l'essai de cycle thermique est compris entre 1,0 et 2,0.

2. Feuille à rayonnement thermique selon la revendication 1, dans laquelle le rapport de surface (S2/S1) est compris entre 1,0 et 1,7.

3. Stratifié en feuille à rayonnement thermique (10, 10A), comprenant
la feuille à rayonnement thermique (1, 200) selon la revendication 1 ou 2, qui présente une première surface et une deuxième surface du côté opposé à la première surface ; et
une couche de graisse à rayonnement thermique (11, 11A, 12, 43, 300) formée sur au moins une surface de la première surface et de la deuxième surface de la feuille à rayonnement thermique.

4. Structure (20, 20A), comprenant
la feuille à rayonnement thermique (1, 200) selon la revendication 1 ou 2,
un élément générateur de chaleur (21) placé sur la feuille à rayonnement thermique, et
une graisse à rayonnement thermique (11, 11A, 12, 43, 300) intervenant entre la feuille à rayonnement thermique et l'élément générateur de chaleur.

5. Procédé de traitement par rayonnement thermique d'un élément générateur de chaleur (21), comprenant
une étape consistant à appliquer sur la feuille à rayonnement thermique (1, 200) selon la revendication 1 ou 2, qui présente une première surface et une deuxième surface du côté opposé à la première surface, une graisse à rayonnement thermique(11, 11A, 12, 43, 300) sur au moins une surface de la première surface et de la deuxième surface ; et
une étape consistant à disposer un élément générateur de chaleur (21) sur la surface de la feuille à rayonnement thermique, sur laquelle la graisse à rayonnement thermique a été appliquée.
